# EUROPÄISCHE PATENTSCHRIFT

(11) **EP 0 315 798 B1**
(45) Veröffentlichungstag und Bekanntmachung des Hinweises auf die Patenterteilung: **27.01.1993**
(21) Anmeldenummer: 88117259.7
(22) Anmeldetag: 17.10.1988
(51) Int. Cl.: H05K 7/14, H05K 9/00

(54) **Etagenschirmblech für einen Baugruppenträger**
Intermediate shielded sheet member for an electronic rack
Tôle intermédiaire de blindage pour rack électronique

(30) Priorität: 30.10.1987 DE 8714497 U
(43) Veröffentlichungstag der Anmeldung: 17.05.1989
(73) Patentinhaber: SIEMENS AKTIENGESELLSCHAFT, 80333 München (DE)
(72) Erfinder: Assel, Eugen, Dipl.-Ing.(FH), D-8729 Knetzgau (DE); Dasbach, Burkhard, Dipl.-Ing. (FH), D-8520 Erlangen (DE); Gebhard, Bruno, Dipl.-Ing. (FH), D-8550 Forchheim (DE)

(56) Entgegenhaltungen:
- GB-A- 802 586
- US-A- 3 340 587
- US-A- 3 502 784
- US-A- 4 114 848

## Beschreibung

Die Erfindung bezieht sich auf ein Etagenschirmblech.

Aus dem Katalog ET 1.1 mit dem Titel "Einbausystem ES 902 C 19-Zoll-Bauweise" der Fa. Siemens AG, Ausgabe 1987, Bestell-Nr. E86010-K4101-A211-A1 ist ein derartiges Etagenschirmblech für einen Baugruppenträger bekannt. Dieses Etagenschirmblech ist allseitig gekantet. Die stirnseitigen Abkantungen des Etagenschirmbleches enthalten eingepreßte Muttern für Sperrzahnschrauben. Verschraubt ist dieses Etagenschirmblech mit den Seitenteilen des Baugruppenträges. Nachteilig bei diesem Etagenschirmblech ist es, daß durch die allseitige Abkantung ein größeres Lager- bzw. Transportvolumen benötigt wird. Außerdem sind zusätzliche Löcher in den Seitenteilen des Baugruppenträgers nötig.

Der Erfindung liegt nun die Aufgabe zugrunde, das eingangs genannte Etagenschirmblech dahingehend zu verbessern, daß das Lager- bzw. Transportvolumen erheblich verringert wird und daß das Etagenschirmblech ohne zusätzliche Löcher in Teilen des Baugruppenträgers mit diesem lösbar verbindbar ist.

Diese Aufgabe wird gelöst mit dem im Anspruch 1 enthaltenen Etagenschirmblech. Vorteilhafte Ausführungsformen der Erfindung sind in den Unterransprüchen enthalten.

Durch die ebene Ausführungsform des Etagenschirmbleches kann dieses Abschirmblech aus einer Blechtafel oder aus einem gecoilten Band hergestellt werden, wobei bei größeren Stückzahlen und automatisierter Fertigung der zweiten Halbzeug-Ausführungsform der Vorzug gegeben werden sollte. Vorteil dieser Meterware ist es, daß in bestimmten Teilungsschritten, beispielsweise 25 mm, durch einfaches Ablängen für jede Baugruppenträgerbreite ein Abschirmblech hergestellt werden kann. Die entsprechenden Etagenschirmbleche benötigen, bedingt durch ihre ebene Ausführungsform, kaum Lager- bzw. Transportvolumen.

Zur elektrischen Kontaktierung und mechanischen Befestigung des Etagenschirmbleches sind die V-förmigen Befestigungsfedern vorgesehen. Diese Befestigungsfedern werden in die rechteckförmigen Löcher eingelegt, wobei jeweils durch die beiden äußeren Überstände an den Befestigungsfedern ein Durchfallen in das Innere des Baugruppenträgers verhindert wird. Die Befestigungsfedern sind jeweils derart in die rechteckförmigen Löcher eingelegt, daß ihre freien Enden der beiden Schenkel immer in Richtung auf die korrespondierende Querschiene zeigen. Zum Verklinken der Befestigungsfedern kann man diese einzeln oder reihenweise auf Anschlag gegen die korrespondierenden Querschienen schieben. In der verklinkten Position hintergreift jeweils der als Rasthaken ausgebildete Schenkel jeder V-förmigen Befestigungsfeder den Absatz der korrespondierenden Querschiene. Je nach erforderlicher Abschirmung und mechanischer Festigkeit kann die Anzahl der Befestigungsfedern über die Baugruppenträgerbreite variiert werden. Besonders vorteilhaft ist es, daß das Etagenschirmblech ohne zusätzliche Löcher in Baugruppenträgerteile mit diesem verbunden werden kann, wobei die mechanische Verbindung von Etagenschirmblech und Baugruppenträger schnell und einfach zu handhaben ist.

In einer vorteilhaften Ausführungsform der Befestigungsfeder ist das freie Ende des zweiten Schenkel der V-förmigen Befestigungsfeder mit einer Abkantung versehen. Mit Hilfe dieser Abkantung werden beim Verklinken des Etagenschirmbleches vorhandene Oxidschichten auf dem Etagenschirmblech im Kontaktzonenbereich der Befestigungsfeder weggekratzt. Dadurch wird die elektrisch leitfähige Verbindung zwischen dem Etagenschirmblech und dem Baugruppenträger wesentlich verbessert, wodurch Störströme vom Etagenschirmblech besser auf die Trägerkomponenten abgeleitet werden können.

In einer weiteren vorteilhaften Ausführungsform der Befestigungsfeder ist das freie Ende des zweiten Schenkels der V-förmigen Befestigungsfeder mit Kontaktnoppen versehen. Dadurch wird die Kraft zum Verklinken der Befestigungsfeder gegenüber der Ausführungsform mit der Abkantung wesentlich verkleinert, ohne dabei die elektrische Leitfähigkeit zwischen dem Etagenschirmblech und dem Baugruppenträger zu verringern.

Zur weiteren Erläuterung wird auf die Zeichnung Bezug genommen, in der ein Ausführungsbeispiel eines Etagenschirmbleches nach der Erfindung schematisch veranschaulicht ist.
- FIG 1: zeigt ein Etagenschirmblech in einem Baugruppenträger, die
- FIG 2: veranschaulicht eine im Etagenschirmblech eingesetzte Befestigungsfeder, gemäß einem Schnitt II-II nach FIG 1 und die
- FIG 3: zeigt eine verklinkte Befestigungsfeder, gemäß einem Schnitt III-III nach FIG 1.

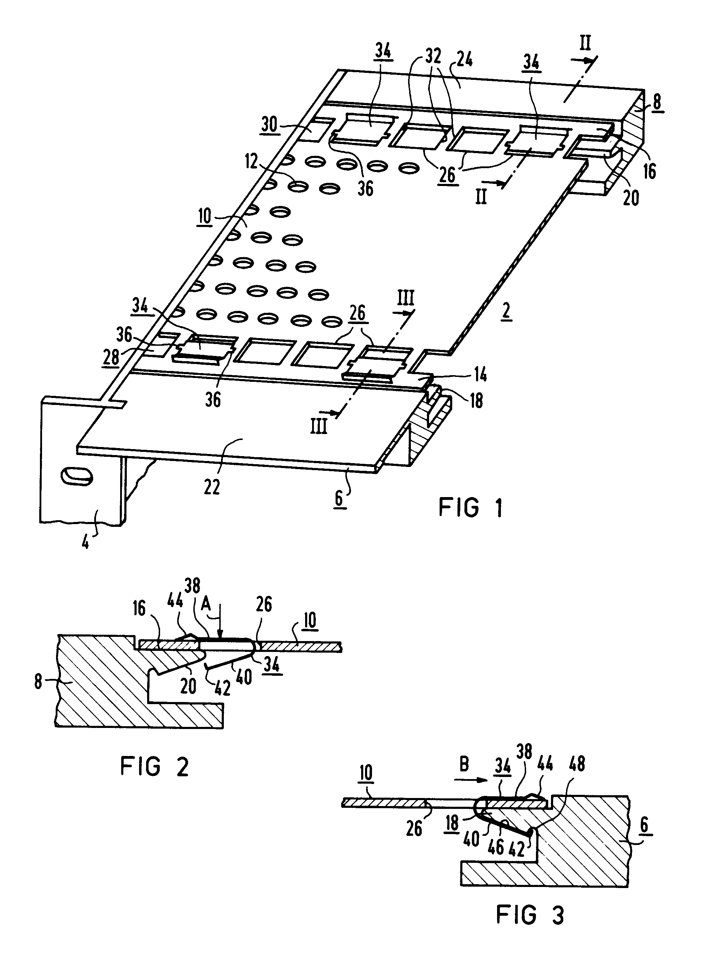

Die FIG 1 zeigt nur einen oberen Teil eines Baugruppenträgers 2, von dem ein Seitenteil 4, eine vordere Querschiene 6, eine hintere Querschiene 8 und ein Etagenschirmblech 10 dargestellt sind. Das Etagenschirmblech 10 besteht aus elektrisch leitendem Material, beispielsweise Aluminium, und ist mit Lüftungslöchern 12 versehen. Außerdem stützt sich das Etagenschirmblech 10 mittels seines Auflagebereichs 14 bzw. 16 auf einen Absatz 18 bzw. 20 der vorderen bzw. hinteren Querschiene 6 bzw. 8 ab. Der Absatz 18 bzw. 20 ist bezogen auf die Oberseite 22 bzw. 24 der vorderen bzw. hinteren Querschiene 6 bzw. 8 derart abgesenkt, daß das Etagenschirmblech annähernd bündig mit der Oberseite 22 bzw. 24 abschließt. Entlang des Auflagebereichs 14 bzw. 16 sind mehrere rechteckförmige Löcher 26 in eine Reihe 28 bzw. 30 nebeneinander angeordnet. Dabei sind die rechteckförmigen Löcher 26 mit ihren Schmalseiten 32 nebeneinander angeordnet. Einige dieser rechteckförmigen Löcher 26 sind mit Befestigungsfeder 34 versehen. Als Befestigungsfedern 34 sind V-förmige Feder aus elektrisch leitendem Material vorgesehen. Dabei sind die Befestigungsfedern 34 der Rechteck-Lochreihe 28 in einer verklinkten Position und die Befestigungsfedern 34 der Rechteck-Lochreihe 30 in einer freien Position. Damit die Befestigungsfedern 34 nach dem Einsetzen in die rechteckförmigen Löcher 26 des Etagenschirmbleches 10 nicht ins Innere des Baugruppenträgers 2 fallen, sind diese jeweils mit seitlichen Überständen 36 versehen.

In FIG 2 ist ein Schnitt entlang der unterbrochenen Linie II-II dargestellt. Diese Schnittdarstellung zeigt eine in einem rechteckförmigen Loch 26 eingesetzte Befestigungsfeder 34. Dabei zeigt der Pfeil A die Richtung des Einsetzen der Befestigungsfeder 34 an. Die V-förmige Befestigungsfeder 34 hält sich mittels seitlicher Überstände 36 nach FIG 1 und mittels des freien Endes seines ersten Schenkels 38 auf dem Etagenschirmblech 10. Das Etagenschirmblech 10 stützt sich mittels des Auflagebereichs 16 auf den Absatz 20 der hinteren Querschiene 8 ab. Der zweite Schenkel 40 der Befestigungsfeder 34 ist entsprechend des korrespondierenden Absatzes 20 gestaltet, wobei das freie Ende dieses Schenkels 40 als Rasthaken 42 ausgebildet ist. Das freie Ende des ersten Schenkels 38 ist mit einer Abkantung 44 versehen.

In FIG 3 ist ein Schnitt entlang der unterbrochenen Linie III-III nach FIG 1 dargestellt. Diese Schnittdarstellung zeigt eine in einem rechteckförmigen Loch 26 verklinkte Befestigungsfeder 34. Gemäß einer Krafteinwirkung, veranschaulicht durch einen Pfeil B, gelangt die Befestigungsfeder 34 aus der Position nach FIG 2 in die dargestellte Position. Beim Verklinken gleitet der Rasthaken 42 des zweiten Schenkels 40 der Befestigungsfeder 34 auf eine Angleitfläche 46 des Absatzes 18 der vorderen Querschiene 6 entlang, bis die Rastposition erreicht ist. Sobald die Rastposition erreicht ist, rastet der Rasthaken 42 in eine Kerbe 48 des Absatzes 18 ein. Während der Rasthaken 42 auf der Angleitfläche 46 gleitet, kratzt die Abkantung 44 des ersten Schenkels 38 auf dem Etagenschirmblech 10, wodurch im Kontaktzonenbereich entstandene Oxidschichten entfernt werden. In der dargestellten verklinkten Position ist einerseits das Etagenschirmblech 10 verliersicher mit den Querschienen 6 und 8 des Baugruppenträgers 2 mechanisch verbunden und andererseits können Störströme vom Etagenschirmblech 10 schnell auf Teile des Baugruppenträgers 2 abgeleitet werden.

## Patentansprüche

1. Etagenschirmblech (10) für einen Baugruppenträger (2), welches aus elektrisch leitendem Material besteht und mit Lüftungslöchern (12) versehen ist, wobei
a) das Etagenschirmblech (10) eben ist und rechteckförmige Löcher (26) aufweist, welche mit nebeneinanderliegenden Schmalseiten (32) in zwei Reihen (28,30) entlang je eines Auflagebereiches (14,16) des Etagenschirmbleches (10) angeordnet sind, und
b) in die rechteckförmigen Löcher (26) V-förmige, aus elektrisch leitendem Material bestehende und mit seitlichen Überständen (36) versehene Befestigungsfedern (34) mit in Richtung auf die Auflagebereiche (14,16) des Etagenschirmbleches (10) zeigenden Schenkein (38,40) in die Löcher (26) eingelegt sind, und der als ein Rasthaken (42) ausgebildete eine Schenkel (40) in einen vertieften Absatz (18,20) einer Querschiene (6,8) eines Baugruppenträgers (2) einklinkbar ist.

2. Etagenschirmblech (10) nach Anspruch 1, **dadurch gekennzeichnet,** daß das freie Ende des anderen Schenkels (38) der V-förmigen Befestigungsfeder (34) mit einer Abkantung (44) versehen ist.

3. Etagenschirmblech (10) nach Anspruch 1, **dadurch gekennzeichnet,** daß das freie Ende des anderen Schenkels (38) der V-förmigen Befestigungsfeder (34) mit Kontaktnoppen versehen ist.

## Claims

1. Tier sheet-metal shield (10) for a mounting rack (2) which consists of electroconductive material and is provided with ventilation holes (12), whereby
a) the tier sheet-metal shield (10) is level and has rectangular holes (26) which are arranged with narrow sides (32) lying side by side in two rows (28,30) along a bearing region (14,16) of the tier sheet-metal shield (10) in each case, and
b) there are inserted into the rectangular holes (26) V-shaped fastening springs (34), consisting of electroconductive material and provided with lateral projecting lengths (36), with limbs (38,40) pointing in the direction of the bearing regions (14,16) of the tier sheet-metal shield (10) into the holes (26), and the one limb (40) constructed as a stop hook (42) can be latched into a recessed step (18,20) of a crossbar (6,8) of a mounting rack (2).

2. Tier sheet-metal shield (10) according to claim 1, characterized in that the free end of the other limb (38) of the V-shaped fastening spring (34) is provided with a folded edge (44).

3. Tier sheet-metal shield (10) according to claim 1, characterized in that the free end of the other limb (38) of the V-shaped fastening spring (34) is provided with contact knubs.

## Revendications

1. Tôle de blindage (10) formant étagère pour un châssis équipé, constituée en un matériau électriquement conducteur et pourvue d'ouvertures d'aération (12), du type dans lequel
a) ladite tôle de blindage (10) formant étagère est plane et présente des ouvertures rectangulaires (26) qui sont disposées, avec leurs côtés étroits adjacents (32), en deux rangées (28, 30) le long de chacune des surfaces d'appui (14, 16) de la tôle de blindage (10), et
b) des ressorts de fixation (34) dotés d'une forme en V, constitués en un matériau électriquement conducteur, et pourvus de porte-à-faux latéraux (36) et possédant des branches latérales (38, 40) saillantes en direction des surfaces d'appui (14, 16) de la tôle de blindage (10), sont insérés dans les ouvertures rectangulaires (26) et dont une branche latérale (40) est susceptible de s'encliqueter, à la manière d'un crochet d'encliquetage (42), dans un talon creux (18, 20), d'un rail transversal (6, 8) du châssis équipé (2).

2. Tôle de blindage (10) formant étagère, selon la revendication 1, caractérisée en ce que l'extrémité libre de l'autre branche latérale (38) du ressort de fixation en forme de V (34) est munie d'un coude (44).

3. Tôle de blindage (10) formant étagère, selon la revendication 1, caractérisée en ce que l'extrémité libre de ladite autre branche latérale (38) du ressort de fixation en forme de V (34) est munie de bossages de contact.
